# EUROPÄISCHE PATENTSCHRIFT

(11) **EP 0 868 742 B1**
(45) Veröffentlichungstag und Bekanntmachung des Hinweises auf die Patenterteilung: **01.08.2001**
(21) Anmeldenummer: 96945893.4
(22) Anmeldetag: 21.11.1996
(51) Int. Cl.: H01L 21/28, H01L 21/336, H01L 21/033

(54) **VERFAHREN ZUR HERSTELLUNG EINES MOS-TRANSISTORS**
PROCESS FOR PRODUCING AN MOS TRANSISTOR
PROCEDE DE FABRICATION D'UN TRANSISTOR MOS

(30) Priorität: 21.12.1995 DE 19548058
(43) Veröffentlichungstag der Anmeldung: 07.10.1998
(73) Patentinhaber: Infineon Technologies AG, 81669 München (DE)
(72) Erfinder: LUSTIG, Bernhard, D-81737 München (DE)
(74) Vertreter: Zedlitz, Peter, Dipl.-Inf.
(86) Internationale Anmeldenummer: DE9602235
(87) Internationale Veröffentlichungsnummer: WO9723902

(56) Entgegenhaltungen:
- EP-A- 0 480 313
- DE-A- 19 527 131
- US-A- 4 354 896
- US-A- 4 358 340
- IBM TECHNICAL DISCLOSURE BULLETIN, Bd. 33, Nr. 1A, 1.Juni 1990, Seiten 75-77, XP000120044 "LOW SERIES RESISTANCE SOURCE BY SPACER METHODS" in der Anmeldung erwähnt
- IEEE ELECTRON DEVICE LETTERS, Bd. 12, Nr. 1, 1.Januar 1991, Seiten 16-17, XP000162294 SCHMITZ A E ET AL: "A DEEP-SUBMICROMETER MICROWAVE/DIGITAL CMOS/SOS TECHNOLOGY"

## Beschreibung

Im Hinblick auf schnelle Schaltungen richtet sich das Interesse zunehmend auf Silizium- oder Silizium-Germanium-MOSFETS mit kurzer Kanallänge. Mit Siliziumkurzkanal-MOS-Transistoren mit Kanallängen unter 100 nm werden Schaltzeiten im Bereich von 10 ps erreichbar. Die Kanallänge ist dabei über die Abmessung der Gateelektrode abzüglich von Gate-Source und Gate-Drain-Überlapps gegeben.

Aus IBM TDB Band 33, Juni 1990, Seite 75 bis 77, ist bekannt, die Gateelektrode für einen Kurzkanaltransistor unter Verwendung eines Spacers als Ätzmaske zu strukturieren.

Ferner ist bekannt (siehe zum Beispiel US-PS 5 231 038 und DE 42 34 777 A1), die die Kanallänge bestimmende Strukturgröße der Gateelektrode an der Oberfläche des Kanals dadurch zu reduzieren, daß die Gateelektrode mit T-förmigem Querschnitt hergestellt wird. Dazu wird an dem Kanalbereich zugewandten Flanken von Anschlüssen der Source/Drain-Gebiete isolierende Spacer gebildet, oberhalb derer die Gateelektrode gebildet wird. Die Gateelektrode überlappt im oberen Bereich die isolierenden Spacer seitlich. Alternativ (siehe DE 42 34 777 A1) wird die Gateelektrode aus zwei unterschiedlichen Metallschichten gebildet. Nach der Strukturierung der oberen Metallschicht wird die untere Metallschicht unter die seitlichen Abmessungen der oberen Metallschicht zurückgeätzt.

Bei derartigen Schaltgeschwindigkeiten sind die RC-Konstanten der Gateelektroden nicht mehr vernachlässigbar. Zusätzlich steigt der Widerstand der üblicherweise aus dotiertem und eventuell silizidiertem oder mit anderen besser leitfähigen Materialien beschichtetem Polysilizium bestehenden Gateelektrode mit kleinerer Kantenlänge, was zum Beispiel auf Korngrenzeneinflüsse zurückgeführt wird.

Der Erfindung liegt das Problem zugrunde, ein Verfahren zur Herstellung eines MOS-Transistors mit kurzer Kanallänge anzugeben.

Dieses Problem wird erfindungsgemäß gelöst durch ein Verfahren gemäß Anspruch 1. Weitere Ausgestaltungen der Erfindung gehen aus den übrigen Ansprüchen hervor.

Der erfindungsgemäß hergestellte MOS-Transistor weist eine Gateelektrode mit einem T-förmigen Querschnitt auf. Die Gateelektrode weist im unteren Bereich, an der Oberfläche zum Gatedielektrikum, geringere Strukturgrößen auf als im oberen Bereich. Der obere Bereich der Gateelektrode, der dem Gatedielektrikum abgewandt ist, bestimmt den Leitungswiderstand der Gateelektrode. Der untere Bereich der Gateelektrode an der Grenzfläche zum Gatedielektrikum dagegen bestimmt die Kanallänge, die für die Schaltgeschwindigkeit des MOS-Transistors bestimmend ist. Da die Strukturgrößen der Gateelektrode in dem erfindungsgemäßen MOS-Transistor an der Oberfläche zum Gatedielektrikum und an der gegenüberliegenden Oberfläche, die den Leitungswiderstand der Gateelektrode bestimmt, unterschiedlich groß sind, wird die Kanallänge unabhängig vom Kontaktwiderstand der Gateelektrode eingestellt.

Der erfindungsgemäß hergestellte MOS-Transistor ist besonders vorteilhaft einsetzbar bei Kanallängen unter 100 nm, da in diesem Bereich der Widerstand einer Polysilizium enthaltenden Gateelektrode wegen des zunehmenden Einflusses von Korngrenzen stärker ansteigt, als es der Reduzierung der Fläche entspricht.

Ein weiterer Vorteil des erfindungsgemäß hergestellten MOS-Transistors liegt darin, daß auch bei Kanallängen unter 100 nm die Gateelektrode im oberen Bereich zum Beispiel mit Strukturgrößen ≥ 250 nm realisiert werden kann. Damit kann eine weitere Widerstandsreduktion der Gateelektrode durch Aufbringen von Metallsilizid, zum Beispiel Titansilizid, erzielt werden. Es hat sich gezeigt, daß Titansilizid bei Strukturgrößen unter 250 nm zunehmend eine Phase hohen Widerstands aufweist und bei derartig kleinen Strukturen zur Widerstandsreduktion nicht gut geeignet ist.

Die Gateelektrode des MOS-Transistors wird vorzugsweise aus zwei Elektrodenschichten in zwei unabhängigen Strukturierungsschritten hergestellt. Dabei wird zunächst eine erste Elektrodenschicht mit Hilfe einer Spacertechnik so strukturiert, daß sie die Kanallänge des MOS-Transistors bestimmt. Die erste Elektrodenschicht kann alternativ auch durch eine andere Feinstrukturierungstechnik, zum Beispiel mit Hilfe von Elektronenstrahllithographie, strukturiert werden. Anschließend wird eine planarisierende Schicht so gebildet, daß die strukturierte erste Elektrodenschicht im oberen Bereich freiliegt. Außerhalb der strukturierten ersten Elektrodenschicht ist die Oberfläche des Gatedielektrikums von der planarisierenden Schicht bedeckt. Anschließend wird eine zweite Elektrodenschicht abgeschieden und strukturiert. Die Strukturgrößen sind dabei größer als bei der ersten strukturierten Elektrodenschicht.

Die Strukturierung der zweiten Elektrodenschicht kann sowohl unter Verwendung einer Photolackmaske als auch selbstjustierend erfolgen.

Im folgenden wird die Erfindung anhand der Ausführungsbeispiele und der Figuren näher erläutert.
- Figur 1: zeigt ein Substrat mit einem Gatedielektrikum, einer ersten Elektrodenschicht, einer Hilfsschicht und einer Photolackmaske.
- Figur 2: zeigt das Substrat nach Bildung einer Hilfsstruktur und Bildung von Spacern an Flanken der Hilfsstruktur.
- Figur 3: zeigt das Substrat nach Strukturierung der ersten Elektrodenschicht zu Elektrodenstegen.
- Figur 4: zeigt das Substrat nach der Bildung von Source/Drain-Gebieten.
- Figur 5: zeigt das Substrat nach Abscheidung einer SiO₂-Schicht, die die Zwischenräume zwischen benachbarten Elektrodenstegen auffüllt.
- Figur 6: zeigt das Substrat nach Planarisierung der SiO₂-Schicht.
- Figur 7: zeigt das Substrat nach dem Rückätzen der Elektrodenstege.
- Figur 8: zeigt das Substrat nach Abscheiden einer zweiten Elektrodenschicht.
- Figur 9: zeigt das Substrat nach der Herstellung einer T-förmigen Gateelektrode.
- Figur 10: zeigt ein Substrat mit einem Gatedielektrikum, einer ersten Elektrodenschicht, einer Hilfsschicht und einer Photolackmaske.
- Figur 11: zeigt das Substrat nach Bildung einer Hilfsstruktur und Bildung von Spacern an Flanken der Hilfsstruktur.
- Figur 12: zeigt das Substrat nach Strukturierung der ersten Elektrodenschicht zu Elektrodenstegen.
- Figur 13: zeigt das Substrat nach einer LDD-Implantation.
- Figur 14: zeigt das Substrat nach dem Abscheiden einer SiO₂-Schicht, die die Zwischenräume zwischen benachbarten Elektrodenstegen auffüllt.
- Figur 15: zeigt das Substrat nach Planarisieren der SiO₂-Schicht.
- Figur 16: zeigt das Substrat mit einer Maske, die einen Teil der Elektrodenstege abdeckt, der als Teil einer Gateelektrode vorgesehen ist, und nach dem Rückätzen der von der Maske unbedeckten Elektrodenstege.
- Figur 17: 7 zeigt das Substrat nach Abscheiden einer zweiten Elektrodenschicht.
- Figur 18: 3 zeigt das Substrat nach dem Rückätzen der zweiten Elektrodenschicht, wobei die von der Maske unbedeckten Elektrodenstege vollständig entfernt werden und eine Gateelektrode selbstjustiert gebildet wird.

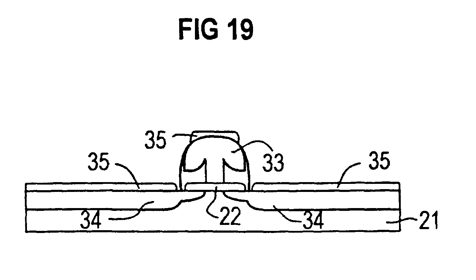

- Figur 19: zeigt das Substrat nach einer Source/Drain-Implantation und Silizidbildung an der Oberfläche der Source/Drain-Gebiete sowie der Gateelektrode.

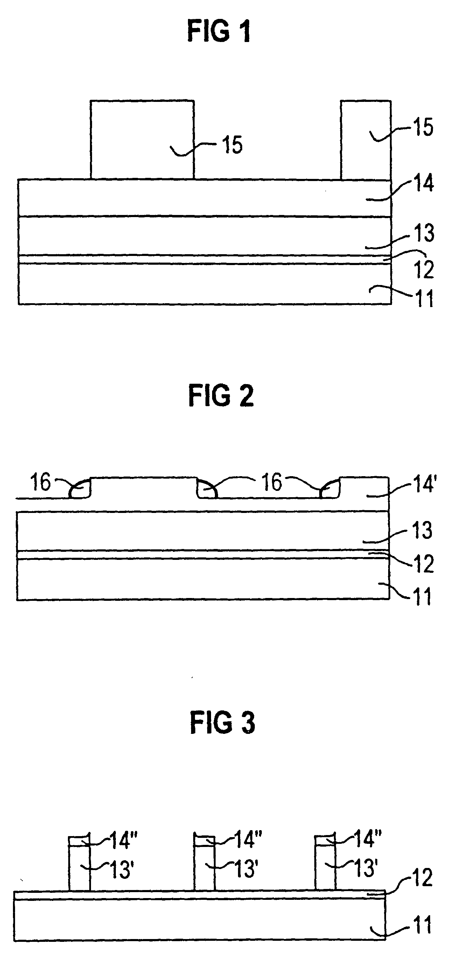

Auf ein Substrat 11, das mindestens im Bereich einer Hauptfläche Silizium umfaßt, zum Beispiel eine monokristalline Siliziumstruktur oder ein SOI-Substrat, wird ein Gatedielektrikum 12 aufgebracht (siehe Figur 1). Das Gatedielektrikum 12 wird zum Beispiel durch thermische Oxidation aus SiO₂ in einer Schichtdicke von 3 bis 4 nm gebildet.

Auf das Gatedielektrikum 12 wird eine erste Elektrodenschicht 13 aufgebracht. Die erste Elektrodenschicht 13 wird zum Beispiel aus dotiertem Polysilizium in einer Schichtdicke von zum Beispiel 200 nm erzeugt.

Auf die erste Elektrodenschicht 13 wird eine Hilfsschicht 14 zum Beispiel durch Abscheidung in einem TEOS-Verfahren aus SiO₂ gebildet. Die Hilfsschicht 14 weist eine Dicke von zum Beispiel 200 nm auf. Auf der Hilfsschicht 14 wird eine Photolackmaske 15 gebildet.

Durch anisotropes Ätzen zum Beispiel mit zum Beispiel CHF₃-RIE (Reactive Ion Etching) wird aus der Hilfsschicht 14 eine Hilfsstruktur 14' gebildet. Die Hilfsstruktur 14' weist im wesentlichen senkrechte Flanken auf. Die Hilfsstruktur 14' bedeckt die Oberfläche der ersten Elektrodenschicht 13 vollständig (siehe Figur 2). Vorzugsweise weist die Hilfsstruktur 14' regelmäßig angeordnete Erhebungen auf.

Durch Abscheiden einer Schicht mit im wesentlichen konformer Kantenbedeckung und anisotropes Rückätzen mit zum Beispiel HBr-RIE (Reactive Ion Etching) werden an den Flanken der Hilfsstruktur 14' Spacer 16 aus Polysilizium gebildet. Die Schicht wird dabei in einer Dicke von zum Beispiel 100 nm abgeschieden. Die Breite der Spacer 16 beträgt zum Beispiel folglich ebenfalls 100 nm. Die Anordnung der Spacer 16 ist durch die Anordnung der Flanken der Hilfsstruktur 14' vorgegeben.

Unter Verwendung der Spacer 16 als Ätzmaske wird durch anisotropes Ätzen zum Beispiel mit CHF₃ und CF₄-RIE (Reactive Ion Etching) die Hilfsschicht 14' strukturiert. Dabei entsteht eine Hartmaske 14'' (siehe Figur 3).

Es wird ein anisotropes Ätzen mit zum Beispiel HBr durchgeführt, bei dem aus der ersten Elektrodenschicht 13 Elektrodenstege 13' gebildet werden. Bei diesem Ätzprozeß werden gleichzeitig die Spacer 16, die ebenfalls aus Polysilizium bestehen, entfernt. Die Hartmaske 14'' wird dagegen bei diesem Ätzprozeß nicht angegriffen und stellt die kantengenaue Übertragung der Struktur auf die Elektrodenstege 13' sicher.

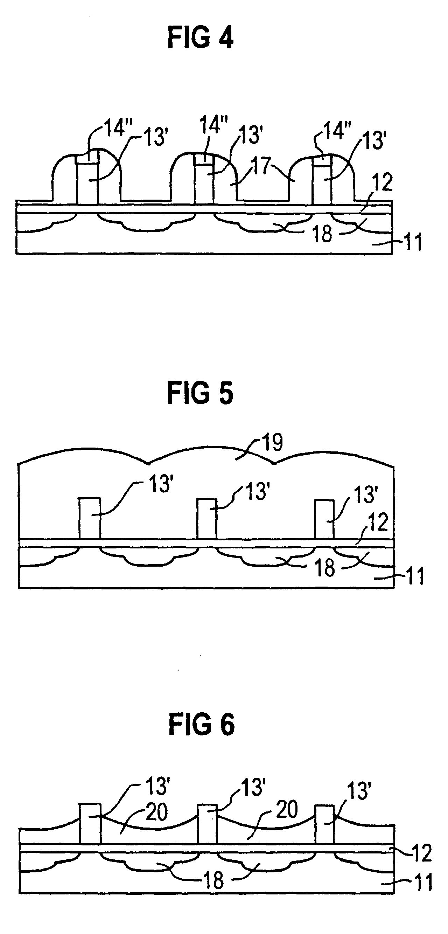

Anschließend werden gegebenenfalls die Flanken der Elektrodenstege 13' mit dünnen SiO₂-Spacern versehen und es wird eine LDD ("lightly doped drain")-Implantation durchgeführt. Diese erfolgt zum Beispiel mit Arsen bei einer Implantationsenergie von 20 keV und einer Dosis von 5 x10¹⁴ cm⁻². Die LDD-Gebiete können auch durch Ausdiffusion aus dotierten Spacern dotiert werden. Anschließend werden dicke SiO₂-Spacer 17 an den Flanken der Elektrodenstege 13' erzeugt und eine HDD-Implantation zur Bildung von Source/Drain-Gebieten 18 durchgeführt (siehe Figur 4). Die HDD ("heavily doped drain")-Implantation erfolgt zum Beispiel mit Arsen bei einer Energie von 90 keV und einer Dosis von 5 x 10¹⁵ cm⁻².

Es wird ganzflächig eine SiO₂-Schicht abgeschieden, zum Beispiel BPSG (Bor-Phosphor-Silicat-Glas) die die Elektrodenstege 13' abdeckt und die die Zwischenräume zwischen benachbarten Elektrodenstegen 13' auffüllt. Mit dem Bezugszeichen 19 ist die SiO₂-Schicht, die dicken SiO₂-Spacer 17, die dünnen SiO₂-Spacer und die Hartmaske 14'' bezeichnet (siehe Figur 5). Die SiO₂-Schicht wird in einer Dicke von zum Beispiel 300 nm abgeschieden.

In einem Planarisierungsschritt, zum Beispiel durch chemischmechanisches Polieren, und/oder Planarisierungsätzen oder ähnliches, wird die SiO₂-Schicht 19 rückgeätzt, bis ihre Dikke geringer ist, als es der Höhe der Elektrodenstege 13' entspricht. Dabei werden die Elektrodenstege 13' im oberen Bereich freigelegt (siehe Figur 6). Zwischen benachbarten Elektrodenstegen 13' bleibt die Oberfläche des Gatedielektrikums 12 aber von der planarisierenden Schicht 20 bedeckt. Im Hinblick auf die Bildung der planarisierenden Schicht 20 ist es vorteilhaft, wenn die Elektrodenstege 13' regelmäßig angeordnet sind. Die Anordnung der Elektrodenstege 13' wird durch die Hilfsstruktur 14' vorgegeben.

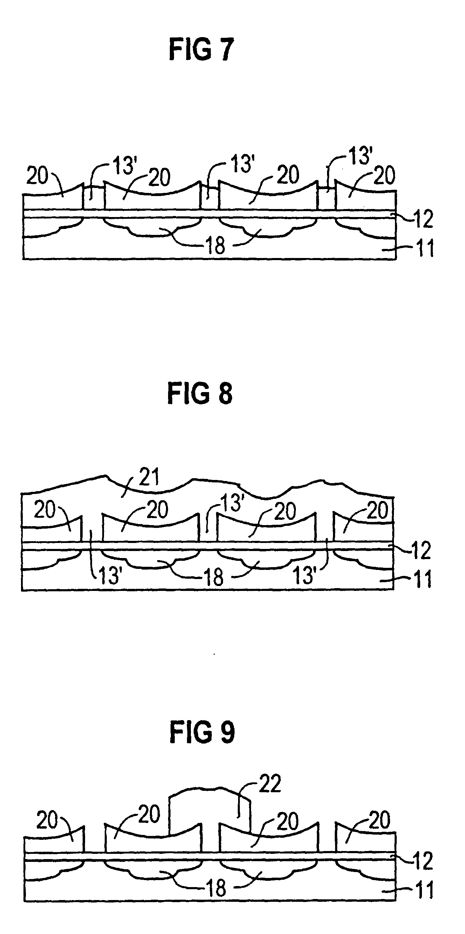

Anschließend werden die Elektrodenstege 13' zum Beispiel naßchemisch mit Cholin bis auf die Höhe der planarisierenden Schicht 20 rückgeätzt (siehe Figur 7). Dieses erfolgt zum Beispiel um 100 nm, um die zweite Elektrodenschicht möglichst planar abscheiden zu können.

Nachfolgend wird ganzflächig eine zweite Elektrodenschicht 21 abgeschieden. Die zweite Elektrodenschicht 21 wird zum Beispiel aus dotiertem Polysilizium in einer Schichtdicke von zum Beispiel 200 nm abgeschieden (siehe Figur 8). Die zweite Elektrodenschicht 21 ist mit den Elektrodenstegen 13' verbunden.

Es wird eine Maske erzeugt (nicht dargestellt), die die Form einer Gateelektrode 22 im oberen Bereich definiert. Durch anisotropes Ätzen zum Beispiel mit HBr wird die zweite Elektrodenschicht 21 außerhalb der Maske und die Elektrodenstege 13' außerhalb der Maske entfernt. Die Ätzung stoppt auf der Oberfläche der planarisierenden Schicht 20 oder, im Bereich der Elektrodenstege 13', des Gatedielektrikums 12. Dabei entsteht die Gateelektrode 22, die einen Teil der Elektrodenstege 13' und einen Teil der zweiten Elektrodenschicht 21 umfaßt (siehe Figur 9). Die Strukturgröße der Gateelektrode 22 an der Oberfläche des Gatedielektrikums 12 wird durch die Breite der Spacer 16 bestimmt. Sie beträgt zum Beispiel 100 nm. Auf der dem Gatedielektrikum 12 abgewandten Seite wird die Strukturgröße der Gateelektrode 22 durch die bei der Strukturierung der zweiten Elektrodenschicht 21 verwendete Maske bestimmt. Die Strukturgröße im oberen Bereich beträgt zum Beispiel 300 nm.

Anschließend wird die planarisierende Schicht 20 selektiv zum Siliziumsubstrat 11 und zur Gateelektrode 22 zurückgeätzt. Dieses erfolgt zum Beispiel durch isotropes Ätzen mit NH₄, HF. Der MOS-Transistor wird gegebenenfalls durch eine zweite HDD-Implantation mit zum Beispiel Arsen bei einer Energie von zum Beispiel 90 keV und einer Dosis von zum Beispiel 5 x 10¹⁵ cm⁻² fertiggestellt. Zusätzlich können die Source/Drain-Gebiete und gegebenenfalls die Gateelektroden silizidiert werden. Diese Schritte sind nicht im einzelnen dargestellt.

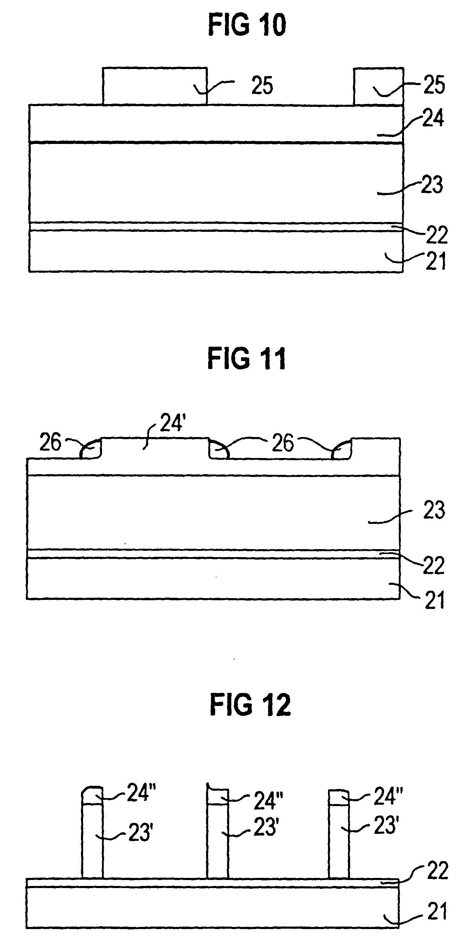

Auf ein Substrat 21, das mindestens im Bereich einer Hauptfläche Silizium aufweist, zum Beispiel eine monokristalline Siliziumscheibe oder ein SOI-Substrat, wird ein Gatedielektrikum 22 aufgebracht. Das Gatedielektrikum 22 wird zum Beispiel durch thermische Oxidation aus SiO₂ in einer Schichtdicke von 3 bis 4 nm gebildet (siehe Figur 10).

Auf das Gatedielektrikum 22 wird eine erste Elektrodenschicht 23 zum Beispiel aus dotiertem Polysilizium in einer Schichtdicke von zum Beispiel 400 nm aufgebracht. Auf die erste Elektrodenschicht 23 wird eine Hilfsschicht 24 zum Beispiel aus TEOS-SiO₂ in einer Schichtdicke von zum Beispiel 200 nm abgeschieden. Auf der Hilfsschicht 24 wird eine Photolackmaske 25 erzeugt.

Durch anisotropes Ätzen zum Beispiel mit zum Beispiel CHF₃-RIE (Reactive Ion Etching) wird aus der Hilfsschicht 24 eine Hilfsstruktur 24' gebildet. Die Hilfsstruktur 24' weist senkrechte Flanken auf. Die Hilfsstruktur 24' bedeckt die Oberfläche der ersten Elektrodenschicht 23 vollständig (siehe Figur 11). Sie weist vorzugsweise regelmäßig angeordnete Erhebungen auf.

Durch Abscheidung einer Polysiliziumschicht mit im wesentlichen konformer Kantenbedeckung in einer Dicke von zum Beispiel 100 nm und anisotropes Rückätzen mit zum Beispiel HBr-RIE (Reactive Ion Etching) werden an den Flanken der Hilfsstruktur 24' Spacer 26 aus Polysilizium gebildet.

Durch anisotropes Ätzen mit zum Beispiel CHF₃, CF₄-RIE (Reactive Ion Etching) wird durch Strukturieren der Hilfsschicht 24' eine Hartmaske 24'' gebildet. Dabei wirken die Spacer 26 als Ätzmaske.

Durch anisotropes Ätzen zum Beispiel mit zum Beispiel HBr wird die erste Elektrodenschicht 23 strukturiert. Dabei entstehen Elektrodenstege 23', die vorzugsweise regelmäßig angeordnet sind (siehe Figur 12). Bei diesem Ätzprozeß werden die Spacer 26 aus Polysilizium entfernt. Da die Ätzung selektiv zu SiO₂ erfolgt, stoppt sie auf der Oberfläche der Hartmaske 24'' sowie des Gatedielektrikums 22.

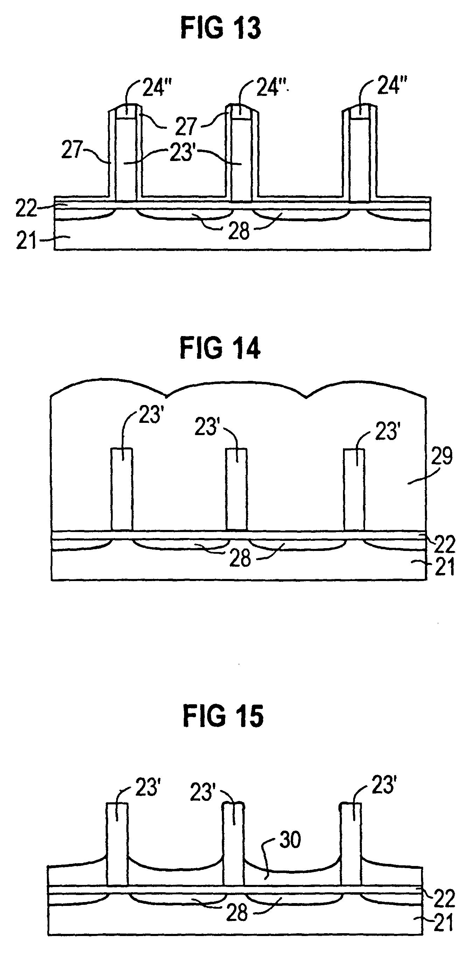

An den Flanken der Elektrodenstege 23' werden gegebenenfalls SiO₂-Spacer 27 für eine LDD-Implantation 28 erzeugt. Die Implantation erfolgt zum Beispiel mit Arsen mit einer Energie von zum Beispiel 20 keV und einer Dosis von 5 x 10¹⁴ cm⁻² (siehe Figur 13). Die LDD-Dotierung kann auch durch Ausdiffusion aus dotierten Spacern erfolgen.

Es wird ganzflächig eine SiO₂-Schicht abgeschieden, die die Zwischenräume zwischen benachbarten Elektrodenstegen 23' auffüllt. In Figur 14 ist mit dem Bezugszeichen 29 die SiO₂-Schicht, die Hartmaske 24'', die SiO₂-Spacer 27 bezeichnet (siehe Figur 14). Die SiO₂-Schicht weist eine Dicke von zum Beispiel 300 nm auf.

Durch Planarisierungsverfahren, zum Beispiel chemischmechanisches Polieren oder Planarisierungsätzen wird aus der SiO₂-Schicht 29 eine planarisierende Schicht 30 gebildet. Für die Planarisierung ist die regelmäßige Anordnung der Elektrodenstege 23' vorteilhaft, aber nicht zwingend erforderlich. Die planarisierende Schicht 30 weist eine geringere Dicke als die erste Elektrodenschicht 23 auf. Die planarisierende Schicht 30 weist eine Dicke von zum Beispiel 100 nm auf (siehe Figur 15). Die Elektrodenstege 23' weisen eine Höhe von zum Beispiel 400 nm auf.

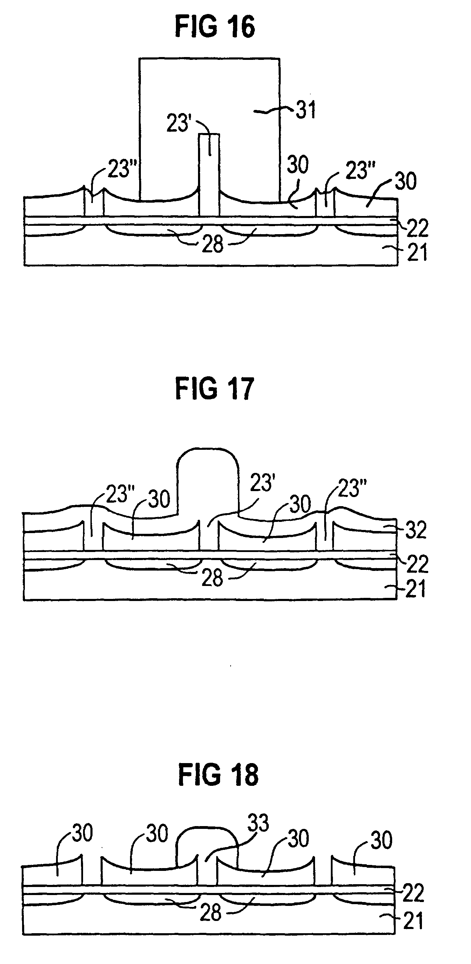

Es wird eine Maske 31 erzeugt, die einen Teil der Elektrodenstege 23' abdeckt, der für eine später herzustellende Gateelektrode vorgesehen sind. Von der Maske 31 unbedeckte Elektrodenstege 23'' werden durch naßchemisches Ätzen mit Cholin auf die Höhe der planarisierenden Schicht 30 zurückgeätzt (siehe Figur 16).

Nach Entfernen der Maske 31 wird ganzflächig eine zweite Elektrodenschicht 32 abgeschieden (siehe Figur 17). Die zweite Elektrodenschicht 32 wird in einer Dicke von zum Beispiel 100 nm aus dotiertem Polysilizium gebildet. Die zweite Elektrodenschicht 32 steht mit den Elektrodenstegen 23'' und 23' in Verbindung.

Durch anisotropes Ätzen zum Beispiel mit HBr wird die zweite Elektrodenschicht 32, ähnlich wie in einer Spacerätzung, rückgeätzt. Gleichzeitig werden die Elektrodenstege 23'', die von der Maske 31 unbedeckt waren, entfernt (siehe Figur 18). Da der von der Maske 31 bedeckte Teil der Elektrodenstege 23' nicht auf die Höhe der planarisierenden Schicht 30 zurückgeätzt worden ist, weist die Struktur in diesem Bereich eine deutlich größere Höhe auf. Beim anisotropen Rückätzen verbleibt daher in diesem Bereich eine Gateelektrode 33. Die Gateelektrode 33 setzt sich zusammen aus dem Teil der Elektrodenstege 23' und dem darüber angeordneten Teil der zweiten Elektrodenschicht 33.

Für diese selbstjustierte Herstellung der Gateelektrode 33 ist es wichtig, daß die Elektrodenstege 23' deutlich über die planarisierende Schicht 30 hinausragen. Die Elektrodenstege 23' überragen die planarisierende Schicht 30 um mindestens die Dicke der planarisierenden Schicht 30. Vorzugsweise weisen die Elektrodenstege 23' ein Verhältnis von Höhe zur Grundseite von ca. 5:1 auf. Das Verhältnis von Höhe der Elektrodenstege 23' zu Dicke der planarisierenden Schicht 30 beträgt zum Beispiel 4:1.

Alternativ können in Figur 16 die überflüssigen Elektrodenstege 23'', die von der Maske 31 unbedeckt sind, vollständig naßchemisch entfernt werden, und die dabei entstehenden Löcher nach Entfernung der Maske 31 durch Abscheiden und Rückätzen von zum Beispiel 70 nm BPSG planarisiert werden. Dann sind niedrigere Elektrodenstege 23' ausreichend. Dann ist in dem Ausführungsbeispiel für das Verhältnis von Höhe zur Grundseite der Elektrodenstege 23' ein Wert von zum Beispiel 3,5:1 anstelle von 5:1 ausreichend.

Durch anisotropes Ätzen mit zum Beispiel CHF₃ wird selektiv zu Silizium der freiliegende Teil der planarisierenden Schicht 30 und des Gatedielektrikums 22 entfernt. Dabei wirkt die Gateelektrode 33 als Maske.

Zur Fertigstellung des MOS-Transistors wird eine HDD-Implantation zum Beispiel mit Arsen bei einer Energie von zum Beispiel 90 keV und einer Dosis von zum Beispiel 5 x 10¹⁵ cm⁻² durchgeführt. Dabei werden Source/Drain-Gebiete 34 gebildet, die auch die LDD-Gebiete 28 mit umfassen. Zum Abschluß werden die Oberflächen der Source/Drain-Gebiete 34 und der Gateelektrode 33 mit einer Metallsilizidschicht 35 zum Beispiel aus Titansilizid versehen.

In beiden Ausführungsbeispielen kann die Hilfsstruktur 14' bzw. 24' auch aus zwei Teilschichten gebildet werden. In diesem Fall wird erst eine SiO₂-Schicht und dann eine Si₃N₄-Schicht aufgebracht. Bei der Strukturierung wird nur die Si₃N₄-Schicht selektiv zu SiO₂ strukturiert.

## Patentansprüche

1. Verfahren zur Herstellung eines MOS-Transistors,
- bei dem in einem Substrat, das mindestens im Bereich einer Hauptfläche Silizium umfaßt, ein Sourcegebiet, ein Draingebiet und ein dazwischen angeordnetes Kanalgebiet erzeugt werden,
- bei dem an der Hauptfläche ein Gatedielektrikum erzeugt wird, das mindestens die Oberfläche des Kanalgebietes bedeckt,
- bei dem ganzflächig eine erste Elektrodenschicht erzeugt wird,
- bei dem auf der ersten Elektrodenschicht Hilfsstrukturen mit im wesentlichen senkrecht zur Hauptfläche ausgerichteten Flanken erzeugt werden,
- bei dem an den Flanken der Hilfsstrukturen Spacer gebildet werden,
- bei dem die erste Elektrodenschicht entsprechend den Spacern strukturiert wird, wobei Elektrodenstege entstehen,
- bei dem eine planarisierende Schicht so gebildet wird, daß die Elektrodenstege im oberen Bereich freiliegen, während die Zwischenräume zwischen benachbarten Elektrodenstegen mit der planarisierenden Schicht gefüllt sind,
- bei dem ganzflächig eine zweite Elektrodenschicht erzeugt wird,
- bei dem durch Ätzung der zweiten Elektrodenschicht eine Gateelektrode aus einem Teil eines der Elektrodenstege und einem Teil der zweiten Elektrodenschicht gebildet wird.

2. Verfahren nach Anspruch 1,
- bei dem zur Bildung der Hilfsstrukturen auf die erste Elektrodenschicht eine Hilfsschicht aufgebracht wird,
- bei dem die Hilfsschicht durch anisotropes Ätzen so strukturiert wird, daß die erste Elektrodenschicht mit der Hilfsschicht bedeckt bleibt, und daß in der Hilfsschicht Vertiefungen mit im wesentlichen senkrechten Flanken gebildet werden.

3. Verfahren nach Anspruch 2,
- bei dem die Spacer an den Flanken der Hilfsstrukturen durch Abscheiden und anisotropes Ätzen einer Schicht mit im wesentlichen konformer Kantenbedeckung gebildet werden,
- bei dem durch anisotropes Ätzen der Hilfsschicht unter Verwendung der Spacer als Ätzmaske eine Hartmaske gebildet wird,
- bei dem unter Verwendung der Hartmaske als Ätzmaske durch anisotropes Ätzen der ersten Elektrodenschicht die Elektrodenstege gebildet werden.

4. Verfahren nach einem der Ansprüche 1 bis 3,
- bei dem zur Bildung der planarisierenden Schicht eine isolierende Schicht abgeschieden wird, deren Dicke mindestens so groß ist wie der halbe Abstand zwischen benachbarten Elektrodenstegen,
- bei dem durch ein Planarisierungsverfahren die isolierende Schicht soweit entfernt wird, bis die Elektrodenstege im oberen Bereich freigelegt sind.

5. Verfahren nach einem der Ansprüche 1 bis 4, bei dem nach der Bildung der Elektrodenstege eine LDD-Implantation durchgeführt wird.

6. Verfahren nach einem der Ansprüche 1 bis 5,
- bei dem die zweite Elektrodenschicht mit Hilfe einer lithographisch erzeugten Maske strukturiert wird.

7. Verfahren nach einem der Ansprüche 1 bis 5,
- bei dem die planarisierende Schicht so gebildet wird, daß der obere Bereich der Elektrodenstege die planarisierende Schicht um mindestens die Dicke der planarisierenden Schicht überragt,
- bei dem eine Maske erzeugt wird, die denjenigen Teil der Elektrodenstege abdeckt, der als Teil der Gateelektrode vorgesehen ist,
- bei dem die von der Maske unbedeckten Teile der Elektrodenstege zurückgeätzt werden,
- bei dem die Maske entfernt wird,
- bei dem nach Bildung der zweiten Elektrodenschicht eine anisotrope Ätzung durchgeführt wird, bei der die von der Maske unbedeckten Teile der Elektrodenstege entfernt werden.

8. Verfahren nach Anspruch 7,
- bei dem nach Bildung der Gateelektrode die planarisierende Schicht durch anisotropes Ätzen strukturiert wird, wobei die Gateelektrode als Maske wirkt,
- bei dem eine Implantation zur Bildung von Sourcegebiet und Draingebiet durchgeführt wird, wobei die Gateelektrode als Maske wirkt,
- bei dem die Gateelektrode sowie das Sourcegebiet und das Draingebiet mit einer Schicht aus Metallsilizid versehen werden.

9. Verfahren nach einem der Ansprüche 1 bis 8, bei dem die erste Elektrodenschicht und die zweite Elektrodenschicht sowie die Spacer aus dotiertem Polysilizium, die Hilfsstrukturen und die planarisierende Schicht aus SiO₂ gebildet werden.

## Claims

1. Method for the production of a MOS transistor,
- in which a source region, a drain region and a channel region arranged in between are produced in a substrate, which comprises silicon at least in the region of a main area,
- in which a gate dielectric, which covers at least the surface of the channel region, is produced on the main area,
- in which a first electrode layer is produced over the whole area,
- in which auxiliary structures having flanks which are aligned essentially perpendicular to the main area are produced on the first electrode layer,
- in which spacers are formed on the flanks of the auxiliary structures,
- in which the first electrode layer is structured in accordance with the spacers, electrode webs being produced,
- in which a planarizing layer is formed in such a way that the electrode webs are exposed in the upper region, whereas the interspaces between neighbouring electrode webs are filled by the planarizing layer,
- in which a second electrode layer is produced over the whole area,
- in which, by etching the second electrode layer, a gate electrode is formed from a part of one of the electrode webs and a part of the second electrode layer.

2. Method according to Claim 1,
- in which an auxiliary layer is applied to the first electrode layer in order to form the auxiliary structures,
- in which the auxiliary layer is structured by means of anisotropic etching in such a way that the first electrode layer remains covered by the auxiliary layer and that depressions having essentially vertical flanks are formed in the auxiliary layer.

3. Method according to Claim 2,
- in which the spacers on the flanks of the auxiliary structures are formed by the deposition and anisotropic etching of a layer with essentially conformal edge covering,
- in which a hard mask is formed by means of anisotropic etching of the auxiliary layer, using the spacers as an etching mask,
- in which the electrode webs are formed by means of anisotropic etching of the first electrode layer, using the hard mask as an etching mask.

4. Method according to one of Claims 1 to 3,
- in which an insulating layer is deposited in order to form the planarizing layer, the thickness of which insulating layer is at least as large as half the distance between neighbouring electrode webs,
- in which the insulating layer is removed by means of a planarization method until the electrode webs are exposed in the upper region.

5. Method according to one of Claims 1 to 4, in which an LDD implantation is carried out following the formation of the electrode webs.

6. Method according to one of Claims 1 to 5,
- in which the second electrode layer is structured with the aid of a lithographically produced mask.

7. Method according to one of Claims 1 to 5,
- in which the planarizing layer is formed in such a way that the upper region of the electrode webs projects beyond the planarizing layer by at least the thickness of the planarizing layer,
- in which there is produced a mask, which covers that part of the electrode webs which is provided as part of the gate electrode,
- in which those parts of the electrode webs which are not covered by the mask are etched back,
- in which the mask is removed,
- in which anisotropic etching is carried out following the formation of the second electrode layer, during which anisotropic etching those parts of the electrode webs which are not covered by the mask are removed.

8. Method according to Claim 7,
- in which, following the formation of the gate electrode, the planarizing layer is structured by means of anisotropic etching, the gate electrode acting as a mask,
- in which an implantation is carried out in order to form the source region and the drain region, the gate electrode acting as a mask,
- in which the gate electrode and also the source region and the drain region are provided with a layer made of metal silicide.

9. Method according to one of Claims 1 to 8,
in which the first electrode layer and the second electrode layer and also the spacers made of doped polysilicon, the auxiliary structures and the planarizing layer are formed from SiO₂.

## Revendications

1. Procédé de fabrication d'un transistor MOS,
- dans lequel on produit dans un substrat, qui comprend au moins dans la région d'une surface principale du silicium, une zone de source, une zone de drain et une zone de canal interposée entre elle,
- dans lequel on produit sur la surface principale un diélectrique de grille qui recouvre au moins la surface de la zone de canal,
- dans lequel on produit sur toute la surface, une première couche d'électrode,
- dans lequel on produit sur la première couche d'électrode, des structures auxiliaires ayant des flancs dirigés sensiblement perpendiculairement à la surface principale,
- dans lequel on forme des espaceurs sur les flancs des structures auxiliaires,
- dans lequel on structure la première couche d'électrode conformément aux espaceurs, en formant des nervures d'électrode,
- dans lequel on forme une couche de planarisation, de sorte que les nervures d'électrode soient mises à nu dans la partie supérieure, tandis que les intervalles, compris entre des nervures d'électrode voisines, sont emplis de la couche de planarisation,
- dans lequel on produit sur toute la surface, une deuxième couche d'électrode,
- dans lequel on forme en attaquant chimiquement la deuxième couche d'électrode, une électrode de grille, constituée d'une partie de l'une des nervures d'électrode et d'une partie de la deuxième couche d'électrode.

2. Procédé suivant la revendication 1,
- dans lequel pour la formation des structures auxiliaires, on dépose sur la première couche d'électrode, une couche auxiliaire,
- dans lequel on structure la couche auxiliaire par attaque chimique anisotrope, de façon que la première couche d'électrode reste recouverte de la couche auxiliaire, et de manière à former dans la couche auxiliaire des cavités, ayant des flancs sensiblement verticaux.

3. Procédé suivant la revendication 2,
- dans lequel on forme les espaceurs sur les flancs des structures auxiliaires, par dépôt et attaque chimique anisotrope d'une couche avec un recouvrement des arêtes sensiblement conformes,
- dans lequel on forme par attaque chimique anisotrope de la couche auxiliaire et en utilisant les espaceurs comme masques d'attaque chimique, un masque dur,
- dans lequel on forme en utilisant le masque dur comme masque d'attaque chimique, par attaque chimique anisotrope de la première couche d'électrode, les nervures d'électrode.

4. Procédé suivant l'une des revendications 1 à 3,
- dans lequel pour la formation de la couche de planarisation, on dépose une couche isolante, dont l'épaisseur est au moins aussi grande que la moitié de la distance comprise entre des nervures d'électrode voisines,
- dans lequel on élimine par un procédé de planarisation, la couche isolante jusqu'à ce que les nervures d'électrode, soient mises à nu dans la partie supérieure.

5. Procédé suivant l'une des revendications 1 à 4,
dans lequel on effectue après la formation des nervures d'électrode, une implantation LDD.

6. Procédé suivant l'une des revendications 1 à 5,
- dans lequel on structure la deuxième couche d'électrode, à l'aide d'un masque produit par voie lithographique.

7. Procédé suivant l'une des revendications 1 à 5,
- dans lequel on forme la couche de planarisation, de façon que la partie supérieure des nervures d'électrode dépasse de la couche de planarisation, d'au moins l'épaisseur de la couche de planarisation,
- dans lequel on produit un masque qui recouvre la partie des nervures d'électrode, qui est prévue comme partie de l'électrode de grille,
- dans lequel on attaque chimiquement en retrait les parties des nervures d'électrode qui ne sont pas recouvertes du masque,
- dans lequel on élimine le masque,
- dans lequel on effectue après la formation de la deuxième couche d'électrode, une attaque chimique anisotrope, dans laquelle on élimine les parties des nervures d'électrode qui ne sont pas recouvertes du masque.

8. Procédé suivant la revendication 7,
- dans lequel après la formation de l'électrode de grille, on structure la couche de planarisation par attaque chimique anisotrope, l'électrode de grille servant de masque,
- dans lequel on effectue une implantation pour la formation de la zone de source et de la zone de drain, l'électrode de grille servant de masque,
- dans lequel on munit l'électrode de grille ainsi que la zone de source et la zone de drain, d'une couche de siliciure métallique.

9. Procédé suivant l'une des revendications 1 à 8,
dans lequel on forme la première couche d'électrode et la deuxième couche d'électrode ainsi que les espaceurs en polysilicium dopés, et les structures auxiliaires et la couche de planarisation en SiO₂.
